# EUROPÄISCHE PATENTSCHRIFT

(11) **EP 2 863 236 B1**
(45) Veröffentlichungstag und Bekanntmachung des Hinweises auf die Patenterteilung: **04.12.2019**
(21) Anmeldenummer: 13004987.7
(22) Anmeldetag: 18.10.2013
(51) Int. Cl.: G01R 31/02, G01R 31/12

(54) **Prüfsystem für Hochspannungskomponenten**
Test system for high voltage components
Système de contrôle pour composants haute tension

(43) Veröffentlichungstag der Anmeldung: 22.04.2015
(73) Patentinhaber: ABB Schweiz AG, 5400 Baden (CH)
(72) Erfinder: Szczechowski, Janusz, 04229 Leipzig (DE); Steiger, Matthias, 06808 Bitterfeld-Wolfen OT Holzweißig (DE)
(74) Vertreter: Marks, Frank

(56) Entgegenhaltungen:
- WO-A1-2012/097825
- JP-A- H11 211 782
- Martin Hässig ET AL: "Grundsteine der TE-Messung an Transformatoren vor Ort Erfahrungen aus off-line-Messungen", Highvolt Kolloquium '03, 1. Januar 2003 (2003-01-01), Seite 207, XP055111326, Dresden Gefunden im Internet: URL:http://fkh.ch/pdf_files/DresdenTrafo.p df [gefunden am 2014-04-01]

## Beschreibung

Die Erfindung betrifft eine Prüfanordnung zur Vor-Ort-TE-Messungen bei Verteiltransformatoren, umfassend wenigsten ein Prüfsystem mit wenigstens folgende Prüfkomponenten: einer Wechselspannungsquelle zur Erzeugung einer variablen Prüfspannung mit einer Messvorrichtung zum Erfassen von TE-bedingten Strompulsen und mit einer Auswertevorrichtung für die erfassten Strompulse, sowie einen geerdeten Prüfbehälter, in dem zumindest einige der Prüfkomponenten angeordnet sind und einen mit der Wechselspannungsquelle verbundenen Verteiltransformator als Prüfling.

Es ist allgemein bekannt, dass Hochspannungskomponenten wie beispielsweise Verteiltransformatoren typische Nennspannungen im Bereich von 10kV bis 110kV bei einer Leistung von einigen 100kVA bis beispielsweise 10MVA und darüber aufweisen. Verteiltransformatoren weisen ein erhebliches Gewicht von beispielsweise einigen t auf und werden in vielen Fällen nicht redundant betrieben. Dennoch sind solche Verteiltransformatoren in bestimmten Intervallen einer Prüfung zu unterziehen, inwieweit sie den Anforderungen an den Netzbetrieb beispielsweise hinsichtlich einer zu erwartenden Ausfallwahrscheinlichkeit Genüge leisten. Regelmäßiger Bestandteil derartiger Prüfungen ist auch eine TE (Teilentladung) Messung.

Die TE-Messung ist eine der wichtigsten zerstörungsfreien Methoden zum Erkennen von Isolationsfehlern. Der Durchschlag eines Isolationsmaterials tritt i.d.R. an einer inneren Schwachstelle auf, welche meist vorab bereits eine Teilentladungsaktivität zeigt. Aus diesem Grund kann die Messung von Teilentladungen helfen, kostenintensive Schäden zu verhindern. Die TE-Messung wird deshalb für Qualitätsprüfungen und zur Diagnose in der Fabrik als auch während der Vor-Ort-Prüfung von Kabeln, GIS, Leistungstransformatoren oder Messwandlern.

Hierbei ist die Vor-Ort-Prüfung von Verteiltransformatoren von großer Bedeutung, da hierbei sowohl ein Transport des Verteiltransformators in ein Prüflabor vermieden wird als auch die prüfungsbedingten Ausfallzeiten erheblich reduziert werden.

Die Hauptkomponenten eines Vor-Ort-TE-Messsystems sind neben einer geeigneten Spannungsquelle und dem Prüfling selbst:
- eine Kopplungskapazität
- ein Hochfrequenz-Stromwandler (TE-Sensoren)
- ein Spektrumanalysator für ein digitales Impulserfassungssystem
- ein digitales Impulserfassungssystem
- ein Speicher-Oszilloskop

Weitere Grundlagen der Vor-Ort TE Messungen sind beispielsweise beschrieben in *"Grundsteine der TE-Messung an Transformatoren Vor-Ort Erfahrungen aus offline-Messungen", Martin Hässig, FKH Jitka Fuhr, ABB Thomas Aschwanden, BKW FMB Energie AG.*

Das Patentdokument JP H11 211782 A offenbart eine Testvorrichtung zur Bestimmung von Teilentladungen, umfassend eine Hochspannungsquelle, eine Messvorrichtung und einen geerdeten Behälter, auf welchem elektrisch isoliert davon ein Prüfling angeordnet ist.

Als nachteilig bei einer Vor-Ort TE Messung erweist es sich, dass der Schwierigkeitsgrad der Interpretation der Resultate einer TE-Messung von der Erscheinungsform, d. h. dem Verhalten der TE-Aktivität im Zeit- und Frequenzbereich, dem TE-Muster und der zeitlichen Stabilität abhängig ist. Ausgehend von diesem Stand der Technik ist es Aufgabe der Erfindung, ein Prüfsystem für Vor-Ort-TE-Messungen bereitzustellen, mit welchem eine Messung von TE Aktivitäten mit einer hohen zeitlichen Stabilität ermöglicht ist, wobei die erzielten Messwerte über einen möglichst langen Zeitraum vergleichbar sind.

Diese Aufgabe wird gelöst von einem Prüfsystem für Hochspannungskomponenten gemäß Anspruch 1. Dieses ist dadurch gekennzeichnet, dass Isolationsmittel vorgesehen sind, auf welchen der Prüfling elektrisch isoliert angeordnet ist und dass der Prüfling zumindest überwiegend mit seinen im normalen Betrieb zu erdenden Teilen mit dem Potential des geerdeten Prüfbehälters verbunden ist.

Die Grundidee der Erfindung besteht darin, störende äußere Einflüsse, welche die Messergebnisse negativ beeinflussen könnten, dadurch zu eliminieren, dass der Prüfling, also in der Regel ein Hochspannungstransformator, vom direkten Erdpotential getrennt wird und auf das Erdpotential des Prüfsystems gelegt wird, welches vorzugsweise zumindest mit einigen seiner Komponenten in einem Prüfbehälter angeordnet ist. Der Prüfbehälter seinerseits ist mit Erde verbunden. Komponenten eines Prüflings, welche üblicherweise mit Erdpotential verbunden sind, sind beispielsweise ein Transformatorkern sowie Befestigungs- und Montagemittel für diesen. Nicht zu derartigen Komponenten gehören insbesondere elektrische Wicklungen.

Somit kann keine Verschleppung des Erdpotentials beziehungsweise ein Einkoppeln von Störungen zwischen Prüfbehälter und Prüfling erfolgen, womit Rausch- und Störeinflüsse, welche eine TE Messung negativ beeinflussen könnten, in vorteilhafter Weise reduziert sind. Optional ist auch der Prüfbehälter zunächst isolierend angeordnet und mit einer separaten Erdungsleitung mit Erdpotential verbunden. Dieses Vorgehen bietet sich in gleichem Maße auch für die Prüfkomponenten an, welche gegebenenfalls nicht im Prüfbehälter angeordnet sind.

Gemäß einer bevorzugten Variante der erfindungsgemäßen Prüfanordnung ist in einem Abstand zum Prüfling, je nach Spannungsebene beispielsweise mindestens 20cm bis 50cm, eine diesen zumindest überwiegend umschließende Umhüllung aus einem leitenden Material vorgesehen. Die Umhüllung ist vorzugsweise mit Erdpotential beziehungsweise mit dem Erdpotential des Prüfcontainers verbunden. Hierdurch werden in vorteilhafter Weise störende äußere Einflüsse, welche die Qualität der Messwerte einer TE Messung negativ beeinflussen könnten, reduziert.

In einer weiterhin bevorzugten Variante des erfindungsgemäßen Prüfsystems ist die Umhüllung ein Zelt aus einer leitenden Folie. Ein derartiges Zelt weist zunächst eine gerüstähnliche Stützstruktur auf, um welche die leitende Folie angeordnet ist. Der Abstand der Folie zum Prüfling ist derart zu bemessen, dass ein Durchschlag zwischen spannungsführenden Komponenten des Prüflings und der Folie ausgeschlossen ist. Typischer Weise ist auch ein direkter Kontakt der Folie mit Komponenten des Prüflings zu vermeiden, auch wenn diese auf Erdpotential beziehungsweise Erdpotential des Prüfcontainers gelegt sind, wie beispielsweise ein Transformatorkern.

Die erfindungsgemäße Aufgabe wird auch gelöst durch ein Verfahren zum Aufbau einer erfindungsgemäßen Prüfanordnung, gekennzeichnet durch folgende Schritte:
- Anordnung des Prüfsystems mit Prüfbehälter in der Nähe des Prüflings,
- Anheben des Prüflings mit einem Hebewerkzeug,
- Positionieren von Isolationsmitteln unter dem Prüfling,
- Absenken des Prüflings auf die Isolationsmittel,
- elektrisches Verschalten der Prüfkomponenten,
- elektrische Verbinden des Erdpotentiales des Prüfbehälters mit den im normalen Betrieb zu erdenden Teilen des Prüflings.

Die erfindungsgemäßen Vorteile, nämlich insbesondere eine Reduktion des Einkoppelns von Rauschen und Störungen über die Erdverbindung, wurden bereits zuvor erläutert. Je nach Größe und Gewicht des Prüflings bieten sich als Hebewerkzeug beispielsweise ein oder auch mehrere Hubwagen an. Als Isolationsmittel kommen beispielsweise Isolationsblöcke aus Keramik, Kunststoff oder Pressspan in Frage. Diese können optional zur Verlängerung des Kriechweges umlaufende Rippen aufweisen. Eine geeignete Höhe eines Isolationsmittels beträgt zum Beispiel je nach Spannungsniveau 5cm bis 25cm.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine exemplarische Prüfanordnung,
- Fig. 2: einen exemplarischen Prüfling mit Erdung sowie
- Fig. 3: einen exemplarischen Prüfling auf Isolationsmitteln.

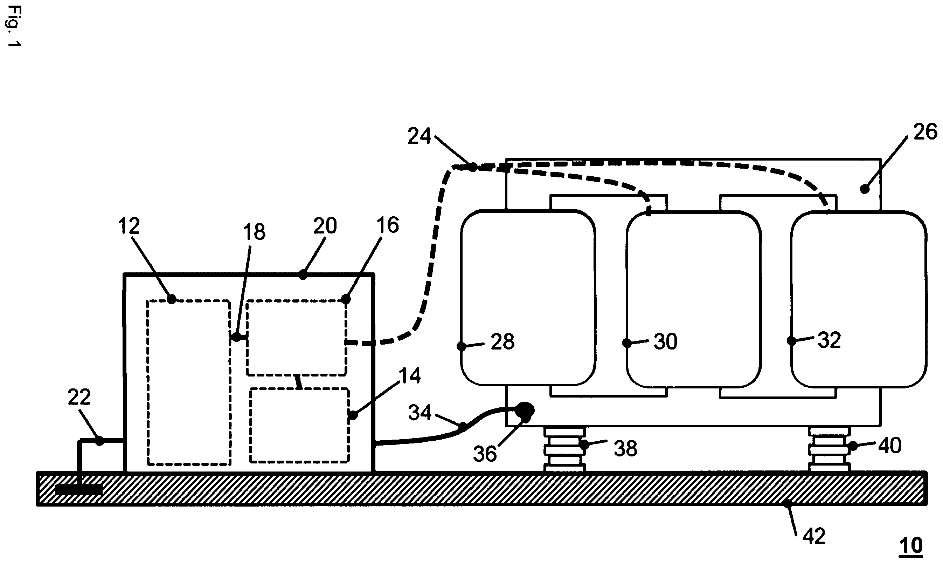

Figur 1 zeigt eine exemplarische Prüfanordnung in einer schematischen Skizze 10. Auf einer Standfläche 42, beispielsweise dem Boden einer Halle, ist ein Prüfbehälter 20 aus einem leitenden Material, beispielsweise Edelstahl, angeordnet. Der Prüfbehälter 20 ist mittels einer Erdung 22 mit Erdpotential verbunden. Innerhalb des Prüfbehälters 20 sind exemplarisch eine Wechselspannungsquelle 12, eine Auswertevorrichtung 14 sowie ein Hochsetztransformator 16 angeordnet, welche mittels elektrischer Verbindungen 18 zu einem betriebsbereiten Prüfsystem verschaltet sind.

Ebenfalls auf der Standfläche 42 angeordnet ist ein zu prüfender Transformator, welcher mit seinen Komponenten Transformatorkern 26 und Spulen 28, 30, 32 dargestellt ist. Der Transformator ist auf Isolationsmitteln 38, 40 befindlich angeordnet, so dass der üblicherweise geerdete Transformatorkern 26 gegenüber Erde isoliert ist. Die Isolationsmittel 38, 40 sind in diesem Fall gerippte Keramikisolatoren von beispielsweise 20cm Höhe.

Zwischen dem im Prüfcontainer 20 angeordneten Prüfsystem und den Wicklungen 28, 30, 32 des Transformators sind elektrische Verbindungsleitungen 24 vorgesehen, um den Transformator als Prüfling in die Prüfanordnung einzubeziehen. Weiterhin ist der Transformator an seinem Erdanschluss 36 gerade nicht direkt mit Erdpotential verbunden sondern vielmehr über eine Verbindungsleitung 34 mit dem Prüfbehälter 20 verbunden und damit auch auf dessen elektrisches Potential gelegt. Auf diese Weise wird ein Einkoppeln von Rauschen oder sonstigen Störeinflüssen in vorteilhafter Weise reduziert, womit die Qualität der Messergebnisse erhöht wird.

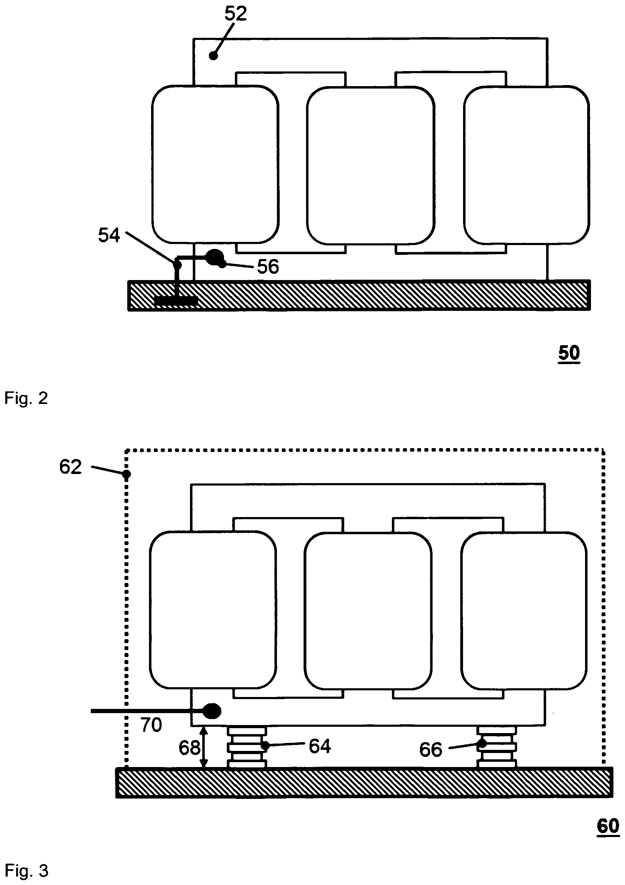

Figur 2 zeigt einen exemplarischen Prüfling, einen Transformator, mit Erdung in einer schematischen Darstellung 50 mit einer Anordnung gemäß dem Stand der Technik. Der Prüfling ist ein Transformator mit Transformatorkern 52 und dessen Schenkel angeordneten Wicklungen. Der Transformatorkern 52 ist direkt auf einer erdverbundenen Standfläche angeordnet und an einem Erdanschluss 56 geerdet. Eine TE Messung an einem derart angeordneten Transformator würde zu einer entsprechend hohen Einkopplung von Rauschen und Störsignalen führen, durch welche eine TE Messung nachteilig beeinflusst wäre.

Figur 3 zeigt einen exemplarischen Prüfling, einen Transformator auf Isolationsmitteln 64, 66, in einer Darstellung 60. Durch die erhöhte Anordnung auf den Isolationsmitteln 64, 66, beispielsweise Isolationsklötzen aus Pressspan, ist ein Abstand 68 gebildet, durch welchen eine elektrische Isolation des Transformators von seiner Standfläche gewährleistet ist. Über eine Verbindungsleitung 70 ist der Transformatorkern mit dem Erdpotential eines Prüfbehälters eines nicht weiter gezeigten Prüfsystems verbunden. Um den Transformator herum ist in einem Abstand eine umschließende Umhüllung, in diesem Fall ein Zelt aus einer leitfähigen Plane, angeordnet. Hierdurch wird in vorteilhafter Weise das Risiko des Einkoppelns eines Störsignales weiter reduziert.

### Bezugszeichenliste

- 10: exemplarische Prüfanordnung
- 12: Wechselspannungsquelle
- 14: Auswertevorrichtung
- 16: Hochsetztransformator
- 18: elektrische Verbindung
- 20: Prüfbehälter
- 22: Erdung des Prüfbehälters
- 24: elektrische Verbindung
- 26: Transformatorkern
- 28: erste Spule
- 30: zweite Spule
- 32: dritte Spule
- 34: Verbindungsleitung Prüfbehälter
- 36: Erdungsanschluss Prüfling
- 38: erstes Isolationsmittel von Prüfling
- 40: zweites Isolationsmittel von Prüfling
- 42: Standfläche
- 50: exemplarischer Prüfling mit Erdung
- 52: Transformatorkern
- 54: Erdung Prüfling
- 56: Erdungsanschluss Prüfling
- 60: exemplarischer Prüfling auf Isolationsmitteln
- 62: umschließende Umhüllung
- 64: erstes Isolationsmittel von Prüfling
- 66: zweites Isolationsmittel von Prüfling
- 68: Abstand
- 70: Verbindungsleitung Prüfbehälter

## Patentansprüche

1. Prüfanordnung (10) zur Vor-Ort-Teilentladung(TE)-Messungen bei Verteiltransformatoren (50), umfassend wenigsten
• ein Prüfsystem mit wenigstens folgende Prüfkomponenten:
• einer Wechselspannungsquelle (12) zur Erzeugung einer variablen Prüfspannung,
• einer Messvorrichtung zum Erfassen von TE-bedingten Strompulsen,
• einer Auswertevorrichtung (14) für die erfassten Strompulse,
• einen geerdeten Prüfbehälter (20), in dem zumindest einige der Prüfkomponenten (12, 14) angeordnet sind,
• sowie einen mit der Wechselspannungsquelle (12) verbundenen Verteiltransformator als Prüfling,
**dadurch gekennzeichnet,**
**dass** Isolationsmittel (38, 40, 64, 66) vorgesehen sind, auf welchen der Prüfling elektrisch isoliert und erhöht angeordnet ist, wobei durch die Isolationsmittel (38, 40, 64, 66) ein Abstand gebildet ist, durch welchen eine elektrische Isolation des Prüflings von seiner Standfläche gewährleistet ist, und dass der Prüfling zumindest überwiegend mit seinen im normalen Betrieb zu erdenden (54) Teilen mit dem Potential des geerdeten (22) Prüfbehälters (20) verbunden (34) ist.

2. Prüfanordnung nach Anspruch 1, **dadurch gekennzeichnet, dass** in einem Abstand zum Prüfling eine diesen zumindest überwiegend umschließende Umhüllung (62) aus einem leitenden Material vorgesehen ist.

3. Prüfanordnung nach Anspruch 2, **dadurch gekennzeichnet, dass** die Umhüllung (62) ein Zelt aus einer leitenden Folie ist.

4. Verfahren zum Aufbau einer Prüfanordnung nach einem der Ansprüche 1 bis 3, **gekennzeichnet durch** folgende Schritte:
• Anordnung des Prüfsystems mit Prüfbehälter (20) in der Nähe des Prüflings,
• Anheben (68) des Prüflings mit einem Hebewerkzeug,
• Positionieren von Isolationsmitteln (38, 40, 64, 66) unter dem Prüfling,
• Absenken des Prüflings auf die Isolationsmittel (38, 40, 64, 66),
• elektrisches Verschalten der Prüfkomponenten (12, 14),
• elektrische Verbinden des Erdpotentiales des Prüfbehälters (20) mit den im normalen Betrieb zu erdenden (54) Teilen des Prüflings.

## Claims

1. Test arrangement (10) for in-situ partial discharge measurements in distribution transformers (50), comprising at least
• one test system having at least the following test components:
• an AC voltage source (12) for producing a variable test voltage,
• a measuring apparatus for recording current pulses caused by partial discharge,
• an evaluation apparatus (14) for the recorded current pulses,
• an earthed test container (20) in which at least some of the test components (12, 14) are arranged,
• and a distribution transformer connected to the AC voltage source (12) as a test object,
**characterized in that**
provision is made of insulation means (38, 40, 64, 66) on which the test object is arranged in an electrically insulated and elevated manner, wherein the insulation means (38, 40, 64, 66) form a distance which ensures that the test object is electrically insulated with respect to its standing area, and **in that** the test object is at least predominantly connected (34) to the potential of the earthed (22) test container (20) by those parts of the test object which need to be earthed (54) during normal operation.

2. Test arrangement according to Claim 1, **characterized in that** a sheath (62) made of a conductive material which at least predominantly surrounds the test object is provided at a distance from the latter.

3. Test arrangement according to Claim 2, **characterized in that** the sheath (62) is a tent made of a conductive film.

4. Method for constructing a test arrangement according to one of Claims 1 to 3, **characterized by** the following steps:
• arranging the test system with the test container (20) in the vicinity of the test object,
• lifting (68) the test object using a lifting tool,
• positioning insulation means (38, 40, 64, 66) under the test object,
• lowering the test object onto the insulation means (38, 40, 64, 66),
• electrically connecting the test components (12, 14),
• electrically connecting the earth potential of the test container (20) to those parts of the test object which need to be earthed (54) during normal operation.

## Revendications

1. Arrangement de contrôle (10) pour des mesures de décharge partielle (TE) sur site sur des transformateurs de distribution (50), comprenant au moins
* un système de contrôle comprenant au moins les composants de contrôle suivants :
* une source de tension alternative (12) destinée à générer une tension de contrôle variable,
* un dispositif de mesure destiné à acquérir des impulsions de courant relatives à la TE,
* un dispositif d'interprétation (14) pour les impulsions de courant acquises,
* un récipient de contrôle (20) relié à la terre, dans lequel sont disposés au moins certains des composants de contrôle (12, 14),
* ainsi qu'un transformateur de distribution relié à la source de tension alternative (12) en tant qu'éprouvette
**caractérisé en ce**
**que** des moyens d'isolation (38, 40, 64, 66) sont présents, sur lesquels l'éprouvette est disposée de manière électriquement isolée et surélevée, les moyens d'isolation (38, 40, 64, 66) formant un écart par lequel une isolation électrique de l'éprouvette de sa surface d'installation est garantie, et **en ce que** l'éprouvette est reliée (34) au moins pour l'essentiel au potentiel du récipient de contrôle (20) relié à la terre (22) par ses parties à relier à la terre (54) en fonctionnement normal.

2. Arrangement de contrôle selon la revendication 1, **caractérisé en ce que** dans un écart par rapport à l'éprouvette se trouve une enveloppe (62) en un matériau conducteur qui entoure celle-ci au moins pour l'essentiel.

3. Arrangement de contrôle selon la revendication 2, **caractérisé en ce que** l'enveloppe (62) est une tente constituée d'un film conducteur.

4. Procédé pour édifier un arrangement de contrôle selon l'une des revendications 1 à 3, **caractérisé par** les étapes suivantes :
* placement du système de contrôle comprenant un récipient de contrôle (20) à proximité de l'éprouvette,
* levage (68) de l'éprouvette avec un engin de levage,
* positionnement de moyens d'isolation (38, 40, 64, 66) sous l'éprouvette,
* abaissement de l'éprouvette sur les moyens d'isolation (38, 40, 64, 66),
* connexion électrique des composants de contrôle (12, 14)
* branchement électrique du potentiel de terre du récipient de contrôle (20) aux parties de l'éprouvette à relier à la terre (54) en fonctionnement normal.
